# EUROPEAN PATENT APPLICATION

(11) **EP 4 679 506 A1**
(43) Date of publication of application: **14.01.2026**
(21) Application number: 24187414.8
(22) Date of filing: 09.07.2024
(51) Int. Cl.: H01L 29/06, H01L 29/861, H01L 29/20, H01L 29/16, H01L 29/24

(54) **POWER SEMICONDUCTOR DEVICE**

(71) Applicant: Hitachi Energy Ltd, 8050 Zürich (CH)
(72) Inventor: Vemulapati, Umamaheswara, 5210 Windisch (CH); Stiasny, Thomas, 8820 Waedenswil (CH); Wikstroem, Tobias, 5704 Egliswil (CH); Corvasce, Chiara, 8962 Bergdietikon (CH); Mitev, Dimitar, 6300 Zug (CH)
(74) Representative: Epping - Hermann - Fischer

(57) **Abstract**

In one embodiment, the power semiconductor device (1) comprises
- a first electrode (21) and a second electrode (22), and
- a semiconductor layer sequence (3),
wherein
- seen along a vertical direction (V), the semiconductor layer sequence (3) comprises a first region (31) of a first conductivity type, a second region (32) adjacent to the second electrode (22) of a second conductivity type, and a reverse layer (44) of the second conductivity type between the first electrode (21) and the first region (31),
- the first region (31) comprises extensions (5, 51, 52, 53) running through the reverse layer (44),
- seen in top view of the first electrode (21), the reverse layer (44) comprises a central area (41), an intermediate area (42) and an edge area (43) in which the extensions (5, 51, 52, 53) have different area proportions and/or sizes, respectively.

## Description

A power semiconductor device is provided.

Documents WO 2023/099298 A1 and WO 2020/201361 A1 refer to semiconductor devices.

Document PCT/EP2024/057773 refers to a power semiconductor device.

A problem to be solved is to provide a power semiconductor device that has improved electrical behavior.

This object is achieved, inter alia, by a power semiconductor device as defined in the independent claim. Exemplary further developments constitute the subject-matter of the dependent claims.

For example, the power semiconductor device comprises a reverse layer which may be p+-doped next to a first electrode, and a plurality of extensions run through the reverse layer. For example, the extensions are n+-doped and may reach the first electrode. The extensions have different area proportions and/or sizes in a central area, an intermediate area and an edge area, respectively, of the reverse layer, seen in top view. It is possible that the power semiconductor device is a fast recovery diode, FRD for short. By having the at least three areas, recovery softness at low currents can be maintained and a maximum forward surge current, IFSM, capability can be improved.

According to at least one embodiment, the power semiconductor device comprises a first electrode and a second electrode. The second electrode and the first electrode can be located on opposing sides of a semiconductor layer sequence of the power semiconductor device. The first and/or the second electrode can be of single-layer fashion or of multi-layer fashion.

According to at least one embodiment, seen along a vertical direction, the semiconductor layer sequence comprises a first region of a first conductivity type. For example, the first region touches the first electrode. It is possible that the first region is composed of a plurality of layers having different maximum doping concentrations.

For example, the vertical direction is a direction perpendicular to the first and/or second electrode. The vertical direction may be in parallel with a direction of main electron flow when the power semiconductor device is in a conductive state. The term 'vertical direction, may not imply 'from below to above' or 'from above to below' so that it may refer to an orientation but not to a vector.

According to at least one embodiment, seen along the vertical direction, the semiconductor layer sequence comprises a second region of a second conductivity type. The second conductivity type is different from the first conductivity type. The conductivity types are n-conductive and p-conductive. The second region is adjacent to the second electrode. That is, the second region may touch the second electrode, for example, all along the second electrode.

According to at least one embodiment, the semiconductor layer sequence comprises a reverse layer of the second conductivity type. The reverse layer is located partially or completely between the first electrode and the first region. For example, the reverse layer is distant from the second region.

According to at least one embodiment, the first region comprises a plurality of extensions. The extensions run through the reverse layer along the vertical direction towards the first electrode. Especially, the extensions completely penetrate the reverse layer and can thus touch the first electrode.

According to at least one embodiment, seen in top view of the first electrode, the reverse layer comprises a central area, an intermediate area and an edge area. In addition to these areas it is in principle possible that there are further areas so that the overall number of areas does not need to be limited to three. For example, there are at most ten or at most six or at most four of such areas.

According to at least one embodiment, the extensions have different area proportions and/or sizes in the central, intermediate and edge areas, respectively. In other words, the different areas can be defined as containing solely or predominantly extensions of a specific area proportion and/or size. 'Predominantly' means, for example, that at least 90% or at least 950 of the extensions have the specific area proportion and/or size assigned to the respective area. For example, the area proportions and/or sizes of the extensions are unique in the central, intermediate and edge areas, respectively. In other words, it is possible that in none of the central, intermediate and edge areas, respectively, there is the same area proportion and/or size of the extensions.

In at least one embodiment, the power semiconductor device comprises
- a first electrode and a second electrode, and
- a semiconductor layer sequence,
   wherein
- seen along a vertical direction, the semiconductor layer sequence comprises a first region of a first conductivity type, a second region adjacent to the second electrode of a second conductivity type different from the first conductivity type, and a reverse layer of the second conductivity type between the first electrode and the first region,
- the first region comprises a plurality of extensions running through the reverse layer along the vertical direction towards the first electrode,
- seen in top view of the first electrode, the reverse layer comprises a central area, an intermediate area and an edge area in which the extensions have different area proportions and/or sizes, respectively.

With this design, an improved performance of fast recovery diodes and reverse conducting integrated gate-commutated thyristors, RC-IGCTs, can be achieved.

Fast recovery diode having cathode segments, that is, a structured cathode at which an n⁺-region is interrupted by shallow p⁺-regions, offer reverse recovery softness. However, there is a trade-off between reverse recovery softness and surge current as well as losses so that there is a technological trade-off. Wider cathode segments offer very soft reverse recovery but surfer in surge current capability and losses. Whereas medium-sized cathode segments offer better surge current capability and improved technology trade-off, such segments lead to a snappier reverse recovery at lower currents.

In the power semiconductor device described herein, the FRD is designed with multiple cathode segment dimensions, for example, with a combination of wider, medium and narrow segments, to improve reverse recovery softness, surge current and technology trade-off compared to either wider cathode segments or medium segments.

Wider cathode segments, that is, for example, wider n⁺-regions and p⁺-regions, offer very soft reverse recovery but poor surge current capability. Medium cathode segments, that is, for example, with medium-sized n⁺-regions and p⁺-regions, offer better surge current capability and improved technology trade-off but are snappier at very low currents.

In the power semiconductor device described herein the FRD is designed with multiple cathode segment dimensions to improve reverse recovery softness, surge current and technology trade-off compared to either wider cathode segments or medium-sized segments. Wider segments in, for example, 10% to 20% of an active area in the center of the device help to improve reverse recovery softness whereas medium-sized segments in 70% to 80% of the active area, for example, help to improve surge current capability and technology trade-off, and narrow segments in, for example, 10% to 20% of the active area near the termination region and in the termination region help to improve frequency turn-off robustness. In addition, using said design can enable to use thinner wafers to produce the power semiconductor device so that costs can be reduced while the use of three instead of one or two structural sizes does not significantly increase production costs as all the segments can be structured using a same mask and/or implantation step.

According to at least one embodiment, the first electrode is a cathode, the second electrode is an anode, the first conductivity type is n-conductive, and the second conductivity type is p-conductive. However, in principle the conductivity types and cathode/anode functionalities could also be the opposite.

According to at least one embodiment, the reverse layer is directly at the first electrode and the extensions touch the first electrode and are in direct contact with the reverse layer. For example, the reverse layer is in direct contact only with the first region and the first electrode and, at a peripheral edge of the semiconductor layer sequence, optionally with a passivation layer of the power semiconductor device.

According to at least one embodiment, the first region comprises a drift region. The drift region may the layer of the first region being most distant from the first electrode. For example, the drift region is the thickest layer of the first region. It is possible that the drift region is in direct contact with the second region. In addition, the first region may comprise a buffer layer between the drift region and the first electrode and a contact layer. The contact layer may constitute the extensions. Further optionally, the extensions may extend into the buffer layer and/or the drift region.

According to at least one embodiment, the central area has at least two axes of mirror symmetry, seen in top view. For example, the central area is of circular shape.

According to at least one embodiment, the intermediate area surrounds the central area, for example, directly surrounds the central area. The intermediate area may directly adjoin the central area, for example, all around. It is possible that the intermediate area is of ring-shape, especially completely around the central area.

According to at least one embodiment, the edge area surrounds the intermediate area, for example, directly surrounds the intermediate area. The edge area may directly adjoin the intermediate area, for example, all around. It is possible that the edge area is of ring-shape, especially completely around the intermediate area.

According to at least one embodiment, seen in top view of the first electrode, the extensions are of island-shape. In other words, there can be a plurality of distinct extensions. The extensions may not touch each other. Thus, directly at the first electrode the extensions may be distant from each other. It is possible that all the extensions or at least the extensions not directly at the peripheral edge are completely surrounded by the reverse layer, especially directly surrounded by the reverse layer. This may be true directly at the first electrode and/or all along the extensions on their way through the reverse layer.

According to at least one embodiment, seen in top view of the first electrode, the extensions have at least one of a circular, ring, triangular, square, rectangular, hexagonal or n-polygonal shape, in case of the n-polygonal shape with n ≥ 8. It is possible that all the extensions have the same basic shape, seen in top view, like being hexagonal. Otherwise, differently shaped extensions can be combined with each other, for example, circular extensions may be combined with square and/or hexagonal extensions.

According to at least one embodiment, the reverse layer is present all along the first electrode. Thus, the reverse layer can be a continuous, uninterrupted layer. This means, for example, that a doping, like a p⁺-doping, is present all over the first electrode.

According to at least one embodiment, the extensions overlap in volume with the reverse layer. For example, a maximum doping concentration of the extensions exceeds a maximum doping concentration of the reverse layer by at least a factor of ten or by at least a factor of 50. In other words, the conductivity type of the reverse layer may be 'overwritten' by the significantly higher implemented doping of the extensions of the other conductivity type. Hence, p-doping and stronger n-doping may be present in the volume of the extensions running through the reverse layer.

Otherwise, it is possible that the reverse layer and the extension do not or do not significantly overlap in volume so that in the volume of the extensions only one doping type, like n-doping, may be present.

According to at least one embodiment, the reverse layer is thinner than the extensions, seen along the vertical direction. Otherwise, the reverse layer and the extensions may have a same thickness or the extensions may even be thicker than the reverse layer.

According to at least one embodiment, first ones of the extensions of the central area are larger than second ones of the extensions of the intermediate area. Alternatively or additionally, the second ones of the extensions are larger than third ones of the extensions of the edge area. For brevity, the first ones of the extensions are referred to as first extensions, and analogously the terms 'second extensions' and 'third extensions, are used.

According to at least one embodiment, first ones of the extensions of the central area are larger than third ones of the extensions of the edge area. Further, the intermediate area comprises a second one of the extensions and said one or plurality of second extensions has an area proportion of at least 70% or of at least 850 of the intermediate area. Hence, it is possible that there is just one second extension and said second extension may completely or virtually completely constitute the intermediate area.

According to at least one embodiment, the first ones of the extensions extend into the intermediate area but not into the edge area. In other words, in the intermediate area there are some of the first extensions. Thus, in the intermediate area the first and second extensions may coexist. For example, at least 90% or at least 950 of the extensions in the intermediate area are second extensions so that the second extensions are the by far predominant species. In this case, the intermediate area may be of ring-shape, for example.

According to at least one embodiment, the intermediate area directly adjoins the central area and the edge area directly adjoins the intermediate area. In this case, there can be exactly the central, intermediate and edge areas without any further areas.

According to at least one embodiment, the edge area is an outermost region of the reverse layer, seen in top view of the first electrode. For example, the edge area forms a peripheral edge of the semiconductor layer sequence, possibly together with other layers and/or regions of the first region.

According to at least one embodiment, the central area, the intermediate area and the edge area are continuous areas. That is, the respective areas are not constituted by subareas but by just one space.

For example, the central area is a simply connected space while the intermediate area and the edge area could be connected spaces of genius 1. Possible further areas may be simply connected spaces or connected spaces of genius 1 as well. Hence, the central area can be a hole-free, uninterrupted area, seen in top view of the first electrode, while the intermediate area and the edge area can have exactly one hole.

According to at least one embodiment, the central area amounts for at least 3% or for at least 5% or for at least 8% or for at least 10% of an active area content. The active area content is, for example, a size of the first electrode and/or of the second electrode, seen in top view of the respective electrode. Especially, the active area content may refer to the size of the second electrode. Alternatively or additionally, said active area content of the central region is at most 30% or is at most 20% or is at most 15%.

According to at least one embodiment, the intermediate area amounts for at least 40% or for at least 60% or for at least 70% or for at least 750 of the active area content. Alternatively or additionally, said active area content of the intermediate region is at most 940 or is at most 90% or is at most 85%.

According to at least one embodiment, the edge area amounts for at least 3% or for at least 5% or for at least 8% or for at least 10% of the active area content. Alternatively or additionally, said active area content of the edge region is at most 30% or is at most 20% or is at most 15%.

It is possible that the above-recited area proportions apply for only the central area, for only the intermediate area, for only the edge area or for any combination of two of said areas or for all three of said areas. In case of more than three areas, it is possible that the above-recited area proportions apply for only one or two of said areas.

According to at least one embodiment, the second electrode is smaller than the first electrode. Hence, seen in top view of the first electrode, the first electrode may protrude all around from the second electrode so that there is a termination region corresponding to an area of the first electrode not covered by the second electrode.

Optionally, a size of the termination region is at least 3% or at least 5% or at least 8% of the active area content, seen in top view of the first electrode. Alternatively or additionally, said size is at most 250 or at most 20% or at most 150 of the active area content.

According to at least one embodiment, seen in top view of the first electrode, an overlap of the termination region and the intermediate area amounts for at least 5% or for at least 8% of the active area content. Alternatively or additionally, said overlap amounts for at most 20% or for at most 150 or for at most 120 of the active area content. It is possible that the termination region is distant from the central area.

According to at least one embodiment, the semiconductor layer sequence becomes thinner in the termination region, for example, starting from the second electrode or from starting near the second electrode and towards the peripheral edge of the semiconductor layer sequence. For example, the semiconductor layer sequence has the shape of a cylinder with a truncated cone on top, or the shape of a prism with a truncated pyramid on top. It is possible that the first region of the semiconductor layer sequence is unaffected by this beveling.

According to at least one embodiment, the power semiconductor device is a FRD or a RC-IGCT.

Optionally, a diameter or a mean diameter of the semiconductor layer sequence is at least 2 cm or is at least 3 cm or is at least 4 cm. Alternatively or additionally, said diameter or mean diameter is at most 0.4 m or is at most 0.3 m or is at most 0.2 m. For the mean diameter, referred to as Dm, it applies, for example: Dm = (4A/π)^{0.5}, with A being the area content of the semiconductor layer sequence, seen in top view of the first electrode.

Optionally, the power semiconductor device is configured for a maximum voltage between the first electrode and the second electrode, in a blocking state of the power semiconductor device, of at least 1.5 kV or of at least 3 kV or of at least 5 kV. Alternatively or additionally, said value is at most 30 kV or is at most 20 kV or is at most 15 kV. The respective maximum voltage defines, for example, a minimum thickness of the first and second regions, a thickness of a passivation layer and/or distances of the first and second electrodes to current-leading components of the power semiconductor device.

According to at least one embodiment, the semiconductor layer sequence is made of silicon, Si. However, the semiconductor layer sequence can alternatively be of a wide-bandgap semiconductor material like SiC, Ga₂O₃ or GaN.

A power semiconductor device described herein is explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
Figures 1 to 5 are schematic sectional views of exemplary embodiments of power semiconductor devices described herein,
Figures 6 to 9 are schematic top views of exemplary embodiments of power semiconductor devices described herein,
Figure 10 are schematic top views of exemplary embodiments of extensions of first regions for power semiconductor devices described herein,
Figure 11 is a schematic top view of an exemplary embodiment of a structuring for power semiconductor devices described herein, and
Figures 12 and 13 are schematic representations of electric data of exemplary embodiments of power semiconductor devices described herein and of comparison devices.

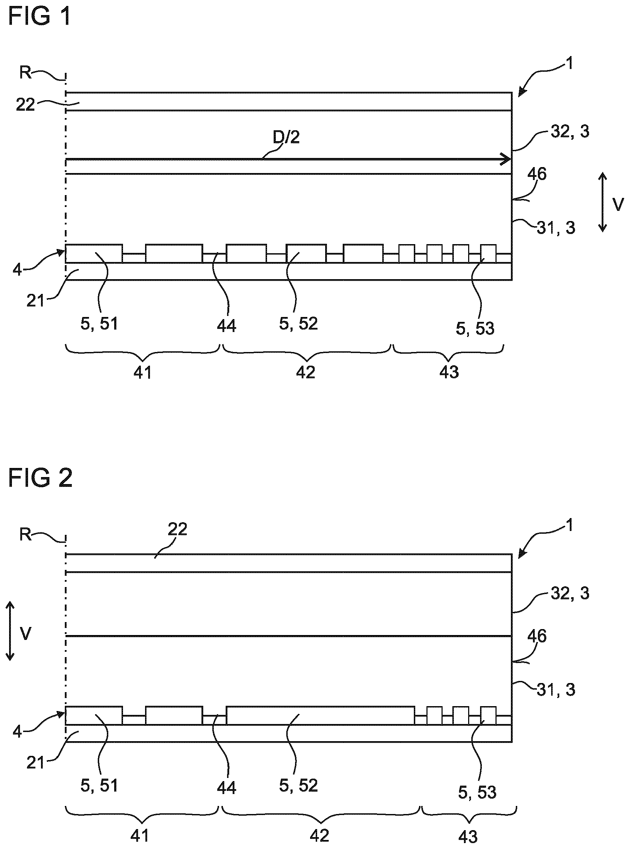

Figure 1 illustrates an exemplary embodiment of a power semiconductor device 1. The power semiconductor device 1 comprises a semiconductor layer sequence 3. The semiconductor layer sequence 3 has a first region 31 and a second region 32. For example, the first region 31 is n-doped and n-conductive and the second region 32 is p-doped and p-conductive, or vice versa. In Figure 1, however, only half the semiconductor layer sequence 3 is shown. Thus, an axis R is an axis of mirror symmetry, for example. It is possible that the axis R is an axis of rotation symmetry.

At the first region 31, there is a first electrode 21 and at the second region 32 there is a second electrode 22. The electrodes 21, 22 are, for example, metallic electrodes. It is possible that the first region 32 and the first electrode 21 are congruent, seen in top view of the first electrode 21. Optionally, the same may apply for the second region 32 and the second electrode 22. A vertical direction R is oriented perpendicular to the first electrode 21, for example, and thus parallel with the axis R.

Moreover, the semiconductor layer sequence 3 includes a reverse layer 44. The reverse layer 44 is arranged between the first electrode 21 and the first region 31. It is possible that the reverse layer 44 is in direct contact with the first electrode 21. If the first region 31 is n-conductive, then the reverse layer 44 is p-conductive.

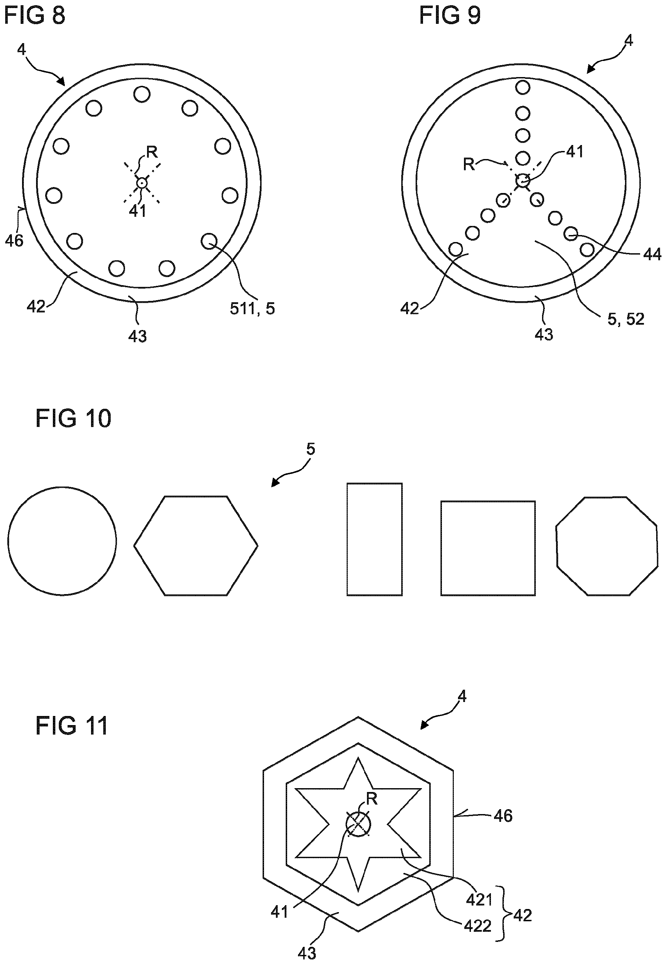

At the reverse layer 44, there is a structuring 4. The structuring 4 is achieved by extensions 5, 51, 52, 53 of the first region 31. Hence, in the extensions 5, 51, 52, 53, the first region 31 extends through the reverse layer 44 to the first electrode 21. The extensions 5, 51, 52, 53 may touch the first electrode 21. As the extensions 5, 51, 52, 53 can be attributed to the first region 31, the extensions 5, 51, 52, 53 are of the same conduction type as the first region 31. See extensions 5, 51, 52, 53 are, for example, of island-shape, seen in top view of the first electrode 21. That is, adjacent extensions 5, 51, 52, 53 as illustrated in Figure 1 may not be connected with each other. Also seen in top view, the extensions 5, 51, 52, 53 may have different shapes, compare also Figure 10 below.

There are three areas 41, 42, 43 in which the extensions 5, 51, 52, 53 have different sizes and/or distances from each other. Alternatively or additionally, the extensions 5, 51, 52, 53 can have different area proportions in the areas 41, 42, 43. For example, 'area proportion' means a quotient of an area occupied by all the respective extensions 5, 51, 52, 53 of a specific one of the areas 41, 42, 43 and area content of said specific one of the areas 41, 42, 43. Thus, not only the sizes of the extensions 5, 51, 52, 53 but also their distances from one another may be different in the areas 41, 42, 43.

In a central one of the areas 41, there are first ones of the extensions 51, and in an intermediate one of the areas 42, there are second ones of the extensions 52, and in an edge one of the areas 43, there are third ones of the extensions 53. The edge area 43 is next to a peripheral edge 46 of the semiconductor layer sequence 3, and the central area 41 surrounds the axis R, for example. The first extensions 51 are larger and more distant from one another than the second extensions 52, and the second extensions 52 are larger and more distant from one another than the third extensions 53.

Concerning an area content of the areas 41, 42, 43, the central area 41 and the edge area 43 are of about the same size whereas the intermediate area 42 is the largest one of the areas 41, 42, 43, for example. An overall diameter D of the semiconductor layer sequence 3 is, for example, at least 90 mm and/or at most 150 mm. Optionally, the power semiconductor device 1 is an FRD or an RC-IGCT.

By way of example, the extensions 5, 51, 52, 53 are thicker than the reverse layer 44. Thus, the extensions 5, 51, 52, 53 may run into the first region 31. This means, for example, that in the extensions 5, 51, 52, 53 the semiconductor layer sequence 3 has a higher maximum or mean doping concentrations than in adjacent parts of the first region 31.

In the embodiment of Figure 2 it is shown that in the intermediate area 42 there is just one second extension 52 that completely fills the intermediate area 42. Accordingly, an area proportion of said second extension 52 on the intermediate area 42 is one or close to one, for example, is at least 0.95 or is at least 0.98.

Otherwise, the same as to Figure 1 may also apply to Figure 2, and vice versa.

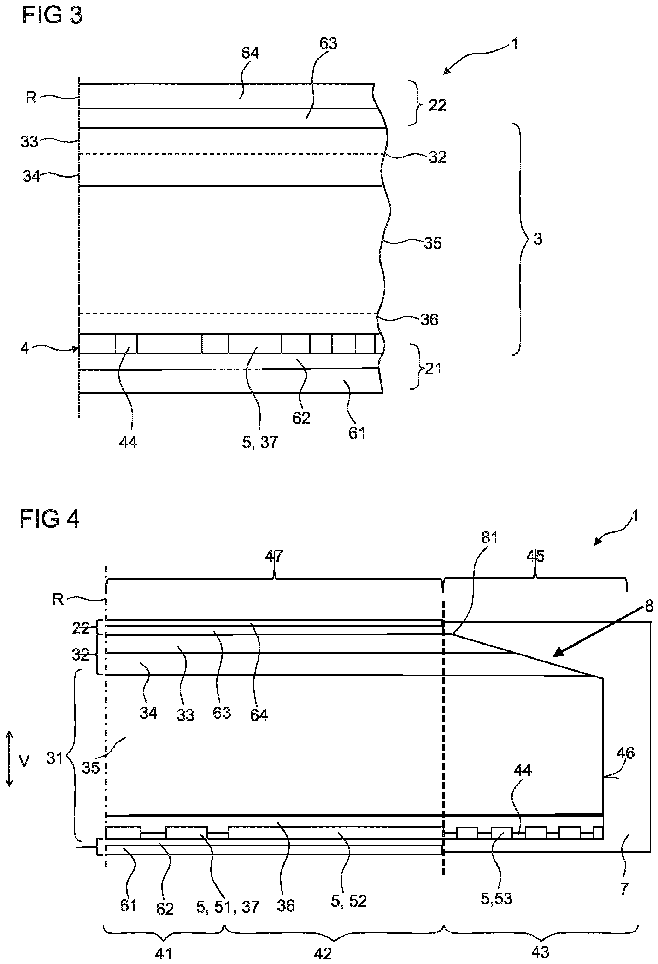

In Figure 3, an exemplary design of the semiconductor layer sequence 3 and of the electrodes 21, 22 is shown in more detail. For example, the second region 32 includes a contact layer 33 directly at the second electrode 22 and a buffer layer 34 directly at the contact layer 33 and at the first region 31. A maximum or mean doping concentration of the contact layer 33 is higher than of the buffer layer 34. As the doping is done by ion implantation, for example, in the individual layers 33, 34, 36, 37, 44 of the semiconductor layer sequence 3 the doping concentration may not be constant but may vary according to a doping profile typical for ion implantation.

For example, a thickness or a design thickness of the contact layer 33 is at least 5 µm and at most 40 µm, depending on a maximum voltage between the electrodes 21, 22 the power semiconductor device 1 is configured for. A doping concentration of the contact layer 33 directly at the second electrode 22 is, for example, at least 1 × 10¹⁷ cm⁻³ and/or is at most 1 × 10¹⁹ cm⁻³. A doping concentration of the buffer layer 34 directly at the contact layer 33 is, for example, at least 1 × 10¹⁵ cm⁻³ and/or is at most 1 × 10¹⁷ cm⁻³. The buffer layer 34 may optionally have a thickness of at least 60 µm and/or of at most 180 µm.

For example, the first region 31 comprises a drift region 35, a buffer layer 36 and a contact layer 37, the latter being composed of the extensions 5, 51, 52, 53. A thickness of the contact layer 37 and, thus, of the extensions 5, 51, 52, 53 may be at least 5 µm and/or at most 40 µm, again dependent on the voltage class of the power semiconductor device 1. A doping concentration of the contact layer 37 directly at the first electrode 21 is, for example, at least 1 × 10²⁰ cm⁻³ and/or is at most 1 × 10²² cm⁻³. The buffer layer 36 may have a thickness of at least 10 µm and/or of at most 50 µm and its doping concentration directly at the contact layer 37 could be, for example, at least 1 × 10¹⁵ cm⁻³ and/or is at most 1 × 10¹⁷ cm⁻³.

The thickest layer of the first region 31 is the drift region 35. In the drift region 35, the doping concentration may be about constant all along the vertical direction V as the drift region 35 may stem from a substrate of the semiconductor layer sequence 3 so that no ion implantation for doping may be required. The drift region 35 may have a thickness of at least 0.3 mm and/or of at most 1.2 mm, depending on the voltage class of the power semiconductor device 1. A maximum or mean doping concentration of the drift region 35 is, for example, at least 1 × 10¹² cm⁻³ and/or is at most 1 × 10¹⁴ cm⁻³.

A thickness of the reverse layer 44 is, for example, the same as the thickness of the contact layer 37, or the reverse layer 44 is thinner than the thickness of the contact layer 37. A minimum thickness of the reverse layer 44 is, for example, at least 30% or at least 50& of the thickness of the contact layer 37. The reverse layer 44 may directly adjoin the first electrode 21 and the buffer layer 36. For example, the reverse layer 44 is present all along the first electrode. In case of an n-conductive first region 31, the reverse layer 44 has a p-doping concentration directly at the first electrode 21, for example, at least 1 × 10¹⁷ cm⁻³ and/or is at most 1 × 10¹⁹ cm⁻³. As the n-doping concentration of the contact layer 37 and, thus, of the extensions 5, 51, 52, 53 is higher than said p-doping, in the extensions 5, 51, 52, 53 the reverse layer 44 is effectively n-conductive but is both p-doped and n-doped, for example.

By way of example, the first and/or the second electrode 21, 22 can optionally be of multilayer-fashion. A first layer 61 of the first electrode 21 comprises or is made of a metal like molybdenum, for example. A second layer 62 is made of or comprises exemplarily aluminum and/or other metals like copper, titanium and/or nickel. In particular, the first layer 61 is configured to be electrically conductively contacted externally and the second layer 62 is a metallization. For example, the metallization is applied in a method using a sputtering process or an evaporation process.

The second electrode 22 can comprise a third layer 63 and a fourth layer 64, being stacked above one another in the vertical direction V. For example, the third layer 63 comprises a metal which is different than a metal comprised by the fourth layer 64. The third layer 63 comprises or consists exemplarily aluminum and/or other metals like copper, titanium, nickel, tungsten, platinum and/or gold and the fourth layer 64 comprises or consists exemplarily molybdenum. In particular, the third layer 63 is a metallization and the further layer 64 is configured to be electrically conductively contacted externally.

All these aspects with regard to the electrodes 21, 22 and the semiconductor layer sequence 3 can individually or in any combination apply for all other examples of the power semiconductor device 1.

Otherwise, the same as to Figures 1 and 2 may also apply to Figure 3, and vice versa.

The example of Figure 4 is based on the embodiment of Figure 2, however, the same can apply for the embodiment of Figure 1, that is, can be the case for the intermediate area 42 being composed by the plurality of the relatively small second extensions 52.

According to Figure 4, the semiconductor layer sequence 3 comprises a termination region 45. The termination region 45 is a region in which the second electrode 22 is not present. The region below the second electrode 22 may be referred to as active region 47 so that an overall area of the semiconductor layer sequence 3 is an area content of the active region 47 plus an area content of the termination region 45. The termination region 45 comprises a beveling 8. The beveling 8 may start at a kink 81 at some distance from the second electrode 22. For example, said distance is at least 0.1% or at least 0.30 of the diameter D and/or is at most 2% or is at most 1% of the diameter D. The kink 81 is at a side of the second region 32 remote from the first region 31.

The beveling 8 may extend into the drift region 35, for example, for at most 10% or for at most 20% of the thickness of the drift region 35 into the latter, seen along the vertical direction V. Optionally, the beveling is of linear shape, but other shapes are also possible.

Further, the edge region 43 can extend into the active region 47. Other than shown it is alternatively also possible that the edge region 43 is limited to the termination region 45, and the regions 43, 45 may be congruent.

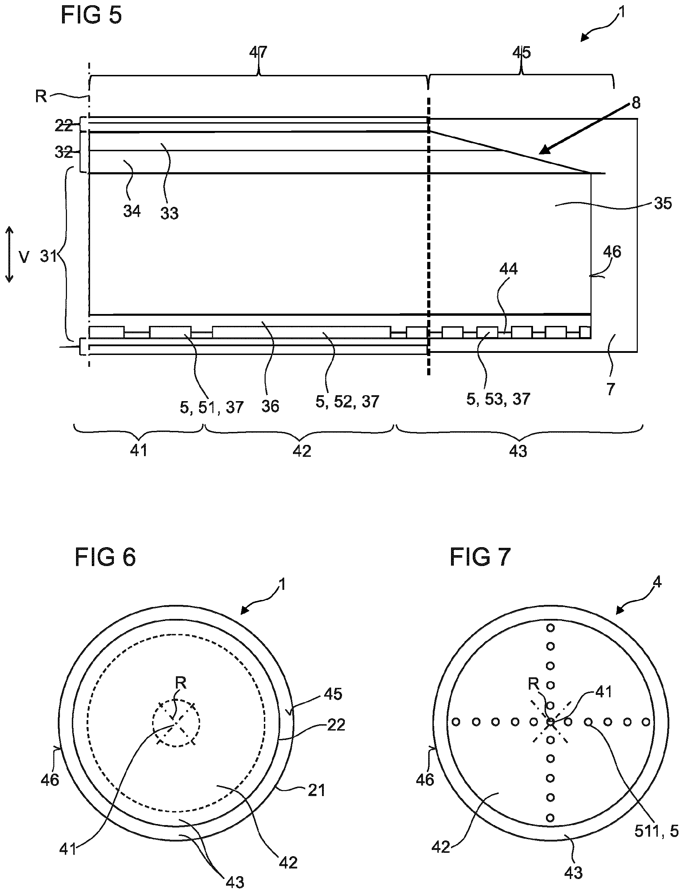

Based on Figure 4, in the example of Figure 5 the beveling 8 starts directly at the second electrode 22. Moreover, as an option it is possible that the beveling 8 terminates with the second region 22, seen along the vertical direction V.

For example, in central region 41, seen in cross-section, a width of individual sections the reverse regions 44 between adjacent extensions 51 is between 0.5 mm and 3 mm, for example, 2.0 mm. A spacing between adjacent sections is, for example, between 0.5 mm and 2.5 mm, like 1.5 mm; the spacing corresponds to a width of the first extensions 51. It is possible that the spacing exceeds the width, optionally by at least a factor of 1.2 and/or by at most a factor of 2.

If structured, like in Figure 1, in the intermediate region 42, seen in cross-section, the spacing is between 0.3 mm and 2 mm, typically 0.8 mm, corresponding to the width of the second extensions 52. The width of the sections, and, thus, the distance between the extensions 52 is between 0.2 mm and 1 mm, like 0.4 mm. It is possible that the width of the extensions 52 exceeds the distance between the extensions 52, for example, by at least a factor of 1.5 and/or by at most a factor of 2.5.

In edge region 43, seen in cross-section, a width of the sections, that is, a distance between the third extensions 53, is between 0.05 mm and 0.5 mm, for example, 0.1 mm to 0.2 mm. The same may apply for the width of the third extensions 53. Hence, said distance and said width 60 µm may be the same or may differ by at most a factor of 1.3 or by at most a factor of 1.1.

These dimensions of the structuring 4 can apply in the same way for all other embodiments, individually or in any combination.

A corresponding top view the device 1 of Figure 5 can be seen in Figure 6.

Otherwise, the same as to Figures 1 to 3 may also apply to Figures 4 to 6, and vice versa. Especially, such a beveling 8 can be present in the device of Figure 1.

In Figures 7 to 9, further examples of the power semiconductor devices 1 are shown. According to Figure 7, the intermediate area 42 has some of the further first extensions 511. For example, the central area 41 may comprise just one first extension 51, and the further first extensions 511 have a same size as the first extensions 51. For example, there are at most 10³ or at most 10² of the further first extensions 511 in the intermediate area 42. It is possible that a number of the second extensions 52 exceed the number of the further first extensions 511 by at least a factor of 10 or by at least a factor of 10² or by at least a factor of 10³.

In Figure 7, the further first extensions 511 extend in a cross-like manner. In Figure 8, the further first extensions 511 form a circle around the central area 41. In Figure 9 it is shown that the further first extensions 511 are arranged in a couple of straight rays emerging from the central area 41. For example, there are at least three and/or at most 15 of such rays, like the three rays of Figure 9. Within the rays, a distance between the further first extensions 511 can be the same as the distance between the first extensions 51 in the central area 41, or the distance between the further first extensions 511 can be larger.

Otherwise, the same as to Figures 1 to 6 may also apply to Figures 7 to 9, and vice versa.

In Figure 10, some examples of basic shapes of the extensions 5, 51, 52, 53 are illustrated in top view. These extensions 5 can be present in all of the embodiments of the device 1, in any combination. For example, all the extensions 5, 51, 52, 53 of the respective device 1 are of the same basic shape as is possible in Figure 1, or the first and third extensions 51, 53 are of the same basic shape and the second extension 52 is of ring-shape as in Figures 2, 4 or 5, for example.

For example, the extensions 5, 51, 52, 53 can be of circular shape, of hexagonal shape, of rectangular shape, of square shape or of polygonal shape, like octagonal. Especially, the extensions 5, 51, 52, 53 are of hexagonal shape.

Otherwise, the same as to Figures 1 to 9 may also apply to Figure 10, and vice versa.

In Figure 11, another example of the power semiconductor device 1 is illustrated. In this case, there are more than three of the areas 41, 42, 43. For example, the intermediate area 42 is split into a first and a second intermediate area 421, 422. This option can be present in all other examples as well.

Further, in Figure 11 it is shown that the areas 41, 42, 421, 422, 43 does not necessarily need to be rotation symmetric. For example, one of the areas 422 may engage into another one of the areas 421. This is possible in all other embodiments, too.

Finally, in Figure 11 the axis R is not an axis of rotation symmetry, but just a central axis. Hence, seen in top view the semiconductor layer sequence 3 does not need to be of circular shape but can have other shapes as well, as polygonal shapes like being a hexagon. This option as well can apply for all other embodiments.

Otherwise, the same as to Figures 1 to 10 may also apply to Figure 11, and vice versa.

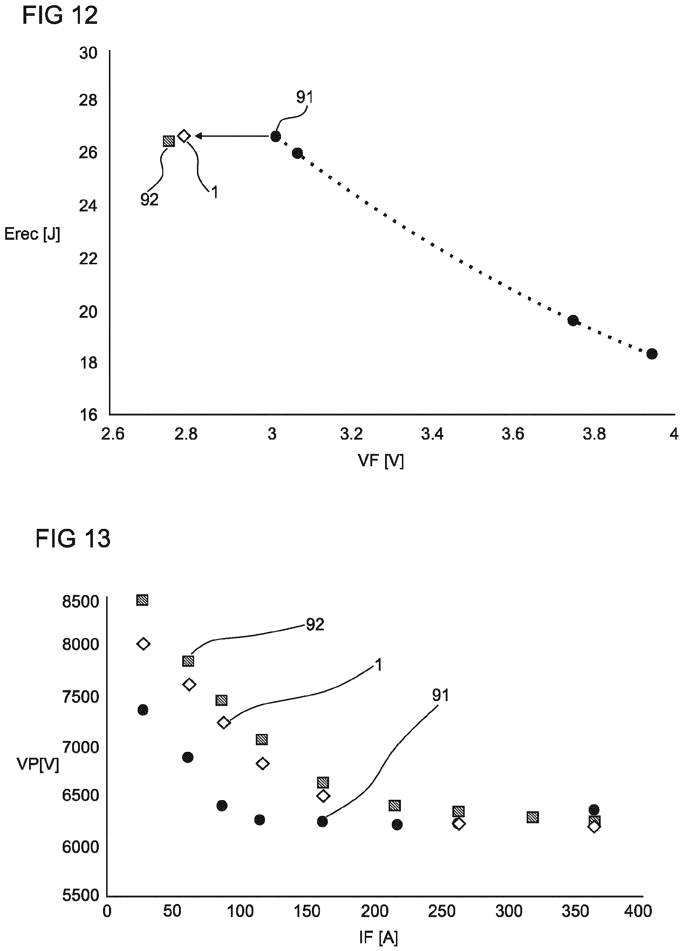

In Figure 12 and 13, some electrical data is illustrated. Compared is a power semiconductor device 1 as described herein, having the first extensions 51 with a width of 1.4 mm and a distance of 1.0 mm in the central area 12 which has a size of 120 of the active region 47 as shown in Figure 4. The intermediate area 42 has the second extensions 52 with a width of 0.8 mm and a distance of 0.4 mm, the size of the intermediate area 42 is 0.8 of the active region 47. In the edge area 43, there are the third extensions 53 with a width and a distance of 0.16 mm. All the extensions 51, 52, 53 are of hexagonal shape, seen in top view. The semiconductor layer sequence 3 is of the design of Figure 3. Thus, the embodiments of Figures 1, 3 and 4 are combined with each other.

In the first comparison device 91, there is no intermediate area but a centrally arranged main area spans until the edge area and has thus a size of about 920 of the active region 47. The extensions of the first comparison device 91 in the main area are as the first extensions 51 of the power semiconductor device 1 of the previous paragraph. The second comparison device 92 corresponds to the first comparison device 91 but with the main extensions being of the configuration of the second extensions 52 of the power semiconductor device 1 of the previous paragraph. Otherwise, the first and second comparison devices 91, 92 correspond to the power semiconductor device 1 of the previous paragraph.

As can be seen from the diagram of Figure 12 showing the forward voltage FV vs. the recovery energy Erec, by combining the first and second extensions 51, 52 the recovery energy Erec can be reduced by about 7.5 percent, compared with the first comparison device 91. At the same time, see the representation of the forward current IF vs. the peak voltage VP in Figure 13, the snap-off behavior can be improved.

Hence, having the central area 41 and the intermediate area 42 with both the first and second extensions 51, 52 offers an improved technological trade-off and overall improved electrical properties.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces may be oriented in parallel with one another. Likewise, unless indicated otherwise, the positions of the drawn components relative to one another are correctly reproduced in the figures.

The invention described here is not restricted by the description on the basis of the exemplary embodiments. Rather, the invention encompasses any new feature and also any combination of features, which includes in particular any combination of features in the patent claims, even if this feature or this combination itself is not explicitly specified in the patent claims or exemplary embodiments.

### List of Reference Signs

- 1: power semiconductor device
- 21: first electrode (cathode)
- 22: second electrode (anode)
- 3: semiconductor layer sequence
- 31: first region of first conductivity type (n-doped)
- 32: second region of second conductivity type (p-doped)
- 33: second contact layer directly at the anode
- 34: second buffer layer
- 35: drift region
- 36: first buffer layer
- 37: first contact layer
- 4: structuring
- 41: central area
- 42: intermediate area
- 421: first intermediate area
- 422: second intermediate area
- 43: edge area
- 44: reverse layer of the second conductivity type
- 45: termination region
- 46: peripheral edge
- 47: active region
- 5: extension of the first region through the reverse layer
- 51: first extension
- 511: first extension extending into the intermediate area
- 52: second extension
- 53: third extension
- 61: first layer
- 62: second layer
- 63: third layer
- 64: fourth layer
- 7: passivation
- 8: beveling
- 81: kink
- 91: first comparison device
- 92: second comparison device
- D/2: half diameter of the semiconductor layer sequence
- Erec: recovery energy
- IF: forward current
- R: axis of rotation symmetry
- V: vertical direction
- VF: forward voltage
- VP: peak voltage

## Claims

1. A power semiconductor device (1) comprising
- a first electrode (21) and a second electrode (22), and
- a semiconductor layer sequence (3),
wherein
- seen along a vertical direction (V), the semiconductor layer sequence (3) comprises a first region (31) of a first conductivity type, a second region (32) adjacent to the second electrode (22) of a second conductivity type different from the first conductivity type, and a reverse layer (44) of the second conductivity type between the first electrode (21) and the first region (31),
- the first region (31) comprises a plurality of extensions (5, 51, 52, 53) running through the reverse layer (44) along the vertical direction (V) towards the first electrode (21),
- seen in top view of the first electrode (21), the reverse layer (44) comprises a central area (41), an intermediate area (42) and an edge area (43) in which the extensions (5, 51, 52, 53) have different area proportions and/or sizes, respectively.

2. The power semiconductor device (1) according to the preceding claim,
wherein the first electrode (21) is a cathode, the second electrode (22) is an anode, the first conductivity type is n-conductive and the second conductivity type is p-conductive,
wherein the reverse layer (44) is directly at the first electrode (21) and the extensions (5, 51, 52, 53) touch the first electrode (21) and are in direct contact with the reverse layer (44),
wherein the first region (31) comprises a drift region (35) which is the layer of the first region (31) being most distant from the first electrode (21), and the drift region (35) is in direct contact with the second region (32).

3. The power semiconductor device (1) according to any one of the preceding claims,
wherein the central area (41) is of circular shape and the intermediate area (42) and the edge area (43) are of ring-shape,
wherein the intermediate area (42) completely surrounds the central area (41) and the edge area (43) completely surrounds the intermediate area (42).

4. The power semiconductor device (1) according to any one of the preceding claims,
wherein, seen in top view of the first electrode (31), the extensions (5, 51, 52, 53) are of island-shape so that directly at the first electrode (31) the extensions (5, 51, 52, 53) are distant from each other and have at least one of circular, ring, triangular, square, rectangular, hexagonal or n-polygonal shape, in case of the n-polygonal shape with n ≥ 8.

5. The power semiconductor device (1) according to any one of the preceding claims,
wherein the reverse layer (44) is present all along the first electrode (21) and the extensions (5, 51, 52, 53) overlap in volume with the reverse layer (44),
wherein a maximum doping concentration of the extensions (5, 51, 52, 53) exceeds a maximum doping concentration of the reverse layer (44) by at least a factor of ten.

6. The power semiconductor device (1) according to any one of the preceding claims,
wherein the reverse layer (44) is thinner than the extensions (5, 51, 52, 53), seen along the vertical direction (V).

7. The power semiconductor device (1) according to any one of the preceding claims,
wherein first ones of the extensions (51) of the central area (41) are larger than second ones of the extensions (52) of the intermediate area (42) and the second ones of the extensions (53) are larger than third ones of the extensions (53) of the edge area (43).

8. The power semiconductor device (1) according to any one of claims 1 to 6,
wherein first ones of the extensions (51) of the central area (41) are larger than third ones of the extensions (53) of the edge area (43),
wherein the intermediate area (42) comprises a second one of the extensions (52), and said second extension (52) has an area proportion of at least 70% of the intermediate area (42) .

9. The power semiconductor device (1) according to any one of the two preceding claims,
wherein the first ones of the extensions (51) extend into the intermediate area (42) but not into the edge area (43).

10. The power semiconductor device (1) according to any one of the preceding claims,
wherein the intermediate area (42) directly adjoins the central area (41) and the edge area (43) directly adjoins the intermediate area (42),
wherein the edge area (43) is an outermost region of the reverse layer (44), seen in top view of the first electrode (21),
wherein the central area (41), the intermediate area (42) and the edge area (43) are continuous areas and the central area (41) is a hole-free, uninterrupted area, seen in top view of the first electrode (21).

11. The power semiconductor device (1) according to any one of the preceding claims,
wherein the central area (41) amounts for at least 3% and at most 30% of an active area content which is a size of the first electrode (21) and/or of the second electrode (22),
wherein the intermediate area (42) amounts for at least 40% and at most 940 of the active area content, and
wherein the edge area (43) amounts for at least 3% and at most 30% of the active area content.

12. The power semiconductor device (1) according to the preceding claim,
wherein the second electrode (22) is smaller than the first electrode (21) so that, seen in top view, the first electrode (21) protrudes all around from the second electrode (22) so that there is a termination region (45) corresponding to an area of the first electrode (21) not covered by the second electrode (22), seen in top view of the first electrode (21),
wherein a size of the termination region (45) is at least 3% and at most 250 of the active area content, seen in top view of the first electrode (21).

13. The power semiconductor device (1) according to the preceding claim,
wherein, seen in top view of the first electrode (21), an overlap of the termination region (45) and the intermediate area (42) amounts for at least 5% and at most 20% of the active area content, and the termination region (45) is distant from the central area (41).

14. The power semiconductor device (1) according to any one of the two preceding claims,
wherein the semiconductor layer sequence (3) becomes thinner in the termination region (45) from the second electrode (22) towards a peripheral edge (46) of the semiconductor layer sequence (3).

15. The power semiconductor device (1) according to any one of the preceding claims,
which is a fast recovery diode, FRD,
wherein a diameter (D) of the semiconductor layer sequence (3) is at least 3 cm and at most 0.3 m,
wherein the power semiconductor device (1) is configured for a maximum voltage between the first electrode (21) and the second electrode (22) in a blocking state of the power semiconductor device (1) of at least 1.5 kV and of at most 30 kV,
wherein the semiconductor layer sequence (3) is made of silicon.
